# EUROPÄISCHE PATENTSCHRIFT

(11) **EP 3 566 037 B1**
(45) Veröffentlichungstag und Bekanntmachung des Hinweises auf die Patenterteilung: **24.02.2021**
(21) Anmeldenummer: 17816653.4
(22) Anmeldetag: 08.12.2017
(51) Int. Cl.: G01L 9/12, B81B 3/00, B81C 1/00

(54) **LINEARISIERTER MIKROMECHANISCHER SENSOR**
LINEARIZED MICROMECHANICAL SENSOR
CAPTEUR MICROMÉCANIQUE LINÉARISÉ

(30) Priorität: 04.01.2017 DE 102017200057
(43) Veröffentlichungstag der Anmeldung: 13.11.2019
(73) Patentinhaber: Robert Bosch GmbH, 70442 Stuttgart (DE)
(72) Erfinder: DANNENBERG, Arne, 72555 Metzingen (DE); DUELL, Andreas, 70567 Stuttgart (DE); ZEHRINGER, Stefan, 72770 Reutlingen (DE); OPPL, Stephan, 72793 Pfullingen (DE); GRUTZECK, Helmut, 72127 Kusterdingen (DE); ZIMMERMANN, Soeren, 72770 Reutlingen (DE); FRANZ, Jochen, 72764 Reutlingen (DE); SCHWARZ, Mike, 72127 Kusterdingen (DE)
(86) Internationale Anmeldenummer: PCT/EP2017/081938
(87) Internationale Veröffentlichungsnummer: WO 2018/127352

(56) Entgegenhaltungen:
- DE-A1- 19 740 244
- US-A1- 2013 000 411
- US-A1- 2015 268 115
- US-A1- 2016 169 760

## Beschreibung

Die Erfindung betrifft einen mikromechanischen Sensor. Insbesondere betrifft die Erfindung einen linearisierten Sensor, bei dem ein Zusammenhang zwischen einem abgetasteten Signal des Sensors und einer abgetasteten physikalischen Größe verbessert linearisiert ist.

Ein mikromechanischer Sensor ist dazu eingerichtet, eine physikalische Größe abzutasten. Diese Größe kann beispielsweise eine Beschleunigung oder einen atmosphärischen Druck betreffen. Dabei ist der mikromechanische Sensor (auch mikro-elektromechanischer oder mikro-mechatronischer Sensor genannt) mit einer Ausdehnung im Bereich von ca. 20 µm bis ca. 1 mm miniaturisiert. Strukturen des mikromechanischen Sensors haben üblicherweise Ausdehnungen zwischen ca. 1 und ca. 100 µm

### Stand der Technik

Der mikromechanische Sensor umfasst üblicherweise ein Substrat und ein bewegliches Element, dessen Position bezüglich des Substrats von der zu bestimmenden physikalischen Größe abhängig ist. Die Position wird mittels eines kapazitiven Sensors bestimmt, der eine erste Elektrode, die am Substrat angebracht ist, und eine zweite Elektrode, die am beweglichen Element angebracht ist, umfasst. Eine Kapazität des Sensors ist von einem relativen Abstand der Elektroden abhängig, sodass die physikalische Größe auf der Basis der Kapazität des Sensors bestimmt werden kann. Allerdings ist der Zusammenhang zwischen der physikalischen Größe und der Kapazität oder Kapazitätsänderung des Sensors üblicherweise hochgradig nichtlinear. Die Linearität kann verbessert werden, indem mehrere kapazitive Sensoren verwendet werden, die gegenläufig durch die Bewegung des beweglichen Elements beeinflusst werden. Insbesondere kann ein Abstand zwischen Elektroden des ersten Sensors ansteigen, wenn ein Abstand zwischen den Elektroden des zweiten Sensors abnimmt und umgekehrt. Die Kapazitäten der Sensoren können einzeln bestimmt und voneinander subtrahiert werden, um ein linearisiertes, auf die physikalische Größe hinweisendes Signal bereitzustellen.

Der Zusammenhang zwischen der physikalischen Größe bzw. der Auslenkung des beweglichen Elements und dem auf der Basis der Kapazitäten bestimmbaren Signal wird dadurch jedoch nur in einem kleinen Teilbereich ausreichend linear. Insbesondere bei einer größeren positiven oder negativen Auslenkung des beweglichen Elements, wenn der Abstand der Elektroden eines der kapazitiven Sensoren gegen null geht, verhält sich der Sensor allgemein stark nichtlinear

Die Patentschriften US 2015/0268115 A1 und DE 197 40 244 A1 offenbaren mikromechanische Drucksensoren gemäß dem Obergriff des Anspruchs 1.

Eine der vorliegenden Erfindung zugrunde liegende Aufgabe besteht darin, eine Technik anzugeben, mittels derer eine verbessert linearisierte Abtastung einer physikalischen Größe mittels eines mikromechanischen Sensors möglich ist. Die Erfindung löst diese Aufgabe mittels der Gegenstände der unabhängigen Ansprüche. Unteransprüche geben bevorzugte Ausführungsformen wieder.

### Offenbarung der Erfindung

Die Erfindung betrifft einen mikromechanischen Sensor gemäß Anspruch 1 und die Verwendung eines Sensors gemäß Anspruch 7.

Ein mikromechanischer Sensor umfasst ein Substrat mit einem Hohlraum; eine elastische Membran, die den Hohlraum überspannt; und ein die Membran überspannendes Hebelelement mit einem ersten und einem zweiten Endabschnitt, wobei die Endabschnitte auf gegenüberliegenden Seiten eines Mittelabschnitts liegen. Zwischen dem ersten Endabschnitt und dem Substrat ist ein erstes Gelenkelement angebracht und zwischen dem Mittelabschnitt und der Membran ist ein zweites Gelenkelement angebracht, sodass das Hebelelement aufgrund einer Auslenkung der Membran geschwenkt werden kann. Ferner sind zwei kapazitive Sensoren mit jeweils zwei Elektroden vorgesehen, wobei eine Elektrode jedes kapazitiven Sensors an einem der Endabschnitte des Hebelelements und die andere am Substrat angebracht ist. Die Elektroden der kapazitiven Sensoren sind derart angeordnet, dass Abstände zwischen den Elektroden verschiedener kapazitiver Sensoren gegenläufig beeinflusst werden, wenn das Hebelelement geschwenkt wird. Darüber hinaus umfasst der mikromechanische Sensor einen Aktuator zur Aufbringung einer Stellkraft zwischen dem Hebelelement und dem Substrat An der Membran ist ein Masseelement angebracht, wobei der Sensor zur Bestimmung einer Beschleunigung eingerichtet ist.

Durch die Stellkraft kann der Sensor in einen Bereich gebracht werden, in dem ein Zusammenhang zwischen einer extern auf die Membran wirkenden physikalischen Größe und einem auf der Basis der Kapazitäten der Sensoren bereitgestellten Signal verbessert linearisiert ist. Ein Messbereich des Sensors oder eine Empfindlichkeit können verbessert sein. Insbesondere kann die Genauigkeit des Sensors über einen vergrößerten Messbereich hin verringerten Schwankungen unterworfen sein.

Es ist besonders bevorzugt, dass der Aktuator auf der Basis einer elektrostatischen Anziehungskraft arbeitet. Dazu umfasst der Aktuator eine am Substrat angebrachte erste Elektrode und eine am Hebelelement angebrachte zweite Elektrode. Wird an die Elektroden eine Stellspannung angelegt, so werden die Elektroden elektrostatisch zueinander hingezogen. Die dabei wirkende Anziehungskraft ist im Wesentlichen abhängig von der Höhe der Stellspannung.

Der elektrostatische Aktuator kann raumsparend aufgebaut sein. Zur Herstellung des Aktuators können die gleichen Prozesse wie zur Herstellung eines der kapazitiven Sensoren verwendet werden. Die elektrostatische Anziehungskraft kann schnell verändert werden und in ihrem Betrag ausreichend groß sein, um das Hebelelement zu betätigen.

Es ist besonders bevorzugt, dass zwei Aktuatoren an unterschiedlichen Endabschnitten des Hebelelements vorgesehen sind. Insbesondere dann, wenn die Aktuatoren elektrostatisch ausgeführt sind, kann so eine resultierende Kraft auf das Hebelelement in beiden Richtungen bewirkt werden. Sind die Sensoren ebenfalls an unterschiedlichen Endabschnitten des Hebelelements vorgesehen, kann eine verbesserte Integration mit den Aktuatoren erfolgen.

Der mikromechanische Sensor kann ferner eine Steuervorrichtung zur Ansteuerung des Aktuators und zur Bestimmung eines von der Auslenkung der Membran abhängigen Signals umfassen. Die Steuervorrichtung kann mit dem kapazitiven Sensor integriert ausgeführt sein. Sowohl der mikromechanische Sensor als auch die Steuervorrichtung können Halbleiter umfassen, die mittels der gleichen oder wenigstens ähnlicher Fertigungsverfahren hergestellt werden können. Durch die Integration können Signalpfade verkürzt und die Kompensation bzw. Vorspannung des Hebelelements zur Linearisierung der Sensorkennlinie verbessert durchgeführt werden. Eine externe Bereitstellung eines Signals zur Ansteuerung des Aktuators kann nicht erforderlich sein.

In einer weiteren Ausführungsform ist die Steuervorrichtung dazu eingerichtet, das von der Auslenkung der Membran abhängige Signal zusätzlich auf der Basis der Kapazitäten der Sensoren zu bestimmen.

Anders ausgedrückt kann in einer ersten Variante der Aktuator auf der Basis der Kapazitäten der Sensoren dazu angesteuert werden, das Hebelelement in eine vorbestimmte Position zu bringen, wobei das auf die physikalische Kraft, die auf die Membran wirkt, hinweisende Signal aus dem Ansteuersignal des Aktuators abgeleitet wird. In einer zweiten Variante wird das Hebelelement auf der Basis der Kapazitäten der Sensoren mittels des Aktuators in einem vorbestimmten Bereich bewegt, in dem der Zusammenhang zwischen der physikalischen Größe und dem Signal ausreichend linear ist. Das Signal wird dann als Überlagerung eines ersten Anteils, das auf der Basis der Ansteuerung des Aktuators bestimmt ist, und eines zweiten Anteils, der aus den Kapazitäten der Sensoren abgeleitet ist, bereitgestellt.

Der beschriebene Sensor kann für unterschiedliche Zwecke genutzt werden. In einer ersten Variante ist der Hohlraum gegenüber einer Umgebung abgeschlossen, wobei der Sensor zur Bestimmung eines atmosphärischen Drucks im Außenbereich eingerichtet ist. In einer Variante besteht bevorzugt eine weitere Öffnung zwischen dem Hohlraum und dem Außenbereich.

Ein Verfahren zum Steuern des oben beschriebenen Sensors umfasst Schritte des Bestimmens von Kapazitäten der kapazitiven Sensoren; des Ansteuerns des Aktuators in Abhängigkeit der bestimmten Kapazitäten, um einen Schwenkwinkel des Hebelelements in einen vorbestimmten Bereich zu bringen; und des Bestimmens eines von der Auslenkung der Membran abhängigen Beschleunigungssignals auf der Basis der Ansteuerung.

Wird das Signal ausschließlich auf der Basis der Ansteuerung des Aktuators bestimmt, so ist der vorbestimmte Bereich des Schwenkwinkels üblicherweise klein. Je größer der Bereich des Schwenkwinkels ist, desto größer kann ein Messfehler sein.

In einer anderen Ausführungsform wird das Signal zusätzlich auf der Basis der Kapazitäten der kapazitiven Sensoren bestimmt. In dieser Ausführungsform ist der vorbestimmte Bereich des Schwenkwinkels bevorzugt so gewählt, dass der Zusammenhang zwischen der physikalischen Größe, die auf die Membran wirkt, und dem auf der Basis der Sensoren bereitgestellten Signal im Wesentlichen linear ist. Dabei ist der vorbestimmte Bereich des Schwenkwinkels üblicherweise deutlich größer. Die Ansteuerung des Aktuators muss erst verändert werden, wenn der Schwenkwinkel droht, aus dem vorbestimmten Bereich zu laufen.

Ist, wie oben genauer beschrieben wurde, der Aktuator dazu eingerichtet, eine elektrostatische Stellkraft auf das Hebelelement auszuüben, so können Elektroden eines der kapazitiven Sensoren mit den Elektroden des Aktuators zusammenfallen. Das beschriebene Verfahren kann das Ansteuern der Elektroden in rascher Folge abwechselnd als kapazitiver Sensor und als Aktuator umfassen. Ein solcher Vorgang ist unter der Bezeichnung Multiplexen bekannt. Die Elektroden können dabei einen größeren Raum einnehmen und somit im Fall des Aktuators effektiver oder im Fall des Sensors sensibler sein. Eine minimale Wechselfrequenz zwischen dem Betrieb als kapazitiver Sensor und als Aktuator richtet sich üblicherweise nach einer Trägheit des Hebelelements bezüglich seines Schwenkwinkels.

### Kurze Beschreibung der Figuren

Die Erfindung wird nun mit Bezug auf die beigefügten Figuren genauer beschrieben, in denen:
- Fig. 1: eine schematische Darstellung eines mikromechanischen Sensors gemäß der Erfindung;
- Fig. 2: einen mikromechanischen Sensor der nicht Teil der Erfindung ist.
- Fig. 3: eine Steuervorrichtung 300 für den mikromechanischen Sensor nach einer der Figuren 1 oder 2; und
- Fig. 4: ein Ablaufdiagramm zum Bestimmen einer physikalischen Größe mittels eines mikromechanischen Sensors nach einer der Figuren 1 oder 2
darstellt.

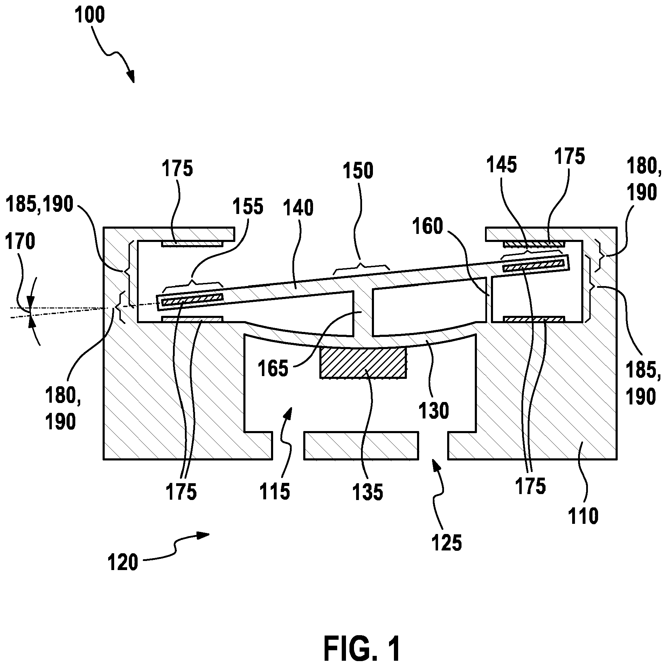

Figur 1 zeigt eine schematische Darstellung eines mikromechanischen Sensors 100 gemäß der Erfindung. In exemplarischer Weise ist die dargestellte Ausführungsform des Sensors 100 zur Bestimmung einer Beschleunigung, in der Darstellung von Figur 1 in vertikaler Richtung, eingerichtet.

Der Sensor 100 umfasst ein Substrat 110, das üblicherweise Silizium oder ein anderes Halbleitermaterial umfasst, wobei im Substrat 110 ein Hohlraum 115 ausgebildet ist. Zum Ausgleichen eines atmosphärischen Drucks zwischen dem Hohlraum 115 und einer Umgebung 120 kann eine Öffnung 125 vorgesehen sein. Über dem Hohlraum 115 ist eine Membran 130 gespannt, die wie das Substrat 110 ein Halbleitermaterial umfassen kann. An ihren Rändern ist die Membran 130 bevorzugt mit dem Substrat 110 verbunden. In einer bevorzugten Ausführungsform ist ein Masseelement 135 an der Membran 130 angebracht, und zwar bevorzugt nahe ihrer Mitte. Wird das Substrat 110 in der Darstellung von Figur 1 in vertikaler Richtung beschleunigt, so bewirkt die Massenträgheit des Masseelements 135 eine vertikale Auslenkung der Membran 130. Das Masseelement umfasst bevorzugt ebenfalls ein Halbleitermaterial.

Über die Membran 130 ist ein Hebelelement 140 gespannt, das einen ersten Endabschnitt 145, einen Mittelabschnitt 150 und einen zweiten Endabschnitt 155 aufweist. Die Endabschnitte 145 und 155 liegen auf unterschiedlichen Seiten des Mittelabschnitts 150. Das gesamte Hebelelement 140 ist daher bevorzugt stabförmig ausgebildet. Ein erstes Gelenkelement 160 ist zwischen dem ersten Endabschnitt 145 und dem Substrat 110 angebracht. Ein zweites Gelenkelement 165 ist zwischen dem Mittelabschnitt 150 und der Membran 130 angebracht. Dabei greift das zweite Gelenkelement 165 bevorzugt in einem Bereich nahe der Mitte der Membran 130 an. Das erste Gelenkelement 160 als auch das zweite Gelenkelement 165 können als separates Element zwischen Hebelelement 140 und Substrat 110 bzw. Membran 130 ausgestaltet sein. Ebenso kann vorgesehen sein, dass wenigstens eine Verbindung eines der Gelenkelemente integral mit dem Hebelelement bzw. dem Substrat und/oder der Membran verbunden ist. Besonders bevorzugt ist, dass wenigstens ein Gelenkelement an einem Ende mit dem Material des Hebelelements und am anderen Ende mit dem Material des Substrats bzw. der Membran integral verbunden ist. Die Gelenkelemente 160 und 165 umfassen bevorzugt ebenfalls Halbleitermaterial.

Das Hebelelement 140 ist mittels der Gelenkelemente 160 und 165 derart schwenkbar bezüglich dem Substrat 110 angebracht, dass ein Schwenkwinkel 170 von einer Auslenkung der Membran 130 abhängig ist. Hebt sich der erste Endabschnitt 145, so senkt sich der zweite Endabschnitt 155 und umgekehrt.

Dabei ist das Substrat 110 im Bereich der Endabschnitte 145 und 155 bevorzugt so geformt, dass jeweils zwei Abschnitte des Substrats 110 auf unterschiedlichen Seiten jedes Endabschnitts 145, 155 bezüglich der Schwenkrichtung des Hebelelements 140 liegen.

An jedem dieser Abschnitte kann eine Elektrode 175 vorgesehen sein. Jeweils eine weitere Elektrode 175 kann an jedem der Endabschnitte 145, 155 des Hebelelements 140 vorgesehen sein. Alternativ dazu kann das Hebelelement 140 auch vollständig aus einem leitfähigen Material, insbesondere einem Metall, hergestellt sein. Zwei erste kapazitive Sensoren 180 umfassen jeweils eine Elektrode 175, die an unterschiedlichen Endabschnitten 145, 155 des Hebelelements 140 angebracht sind, und weitere Elektroden 175, die am Substrat 110 angebracht sind, wobei sich Abstände zwischen den Elektroden 175 jedes ersten kapazitiven Sensors 180 verkleinern, wenn das Hebelelement 140 im Uhrzeigersinn verschwenkt wird. Ferner sind zwei zweite kapazitive Sensoren 185 gebildet, die jeweils eine an unterschiedlichen Endabschnitten 145, 155 des Hebelelements 140 angebrachte Elektrode 175 und zwei am Substrat 110 angebrachte Elektroden 175 umfassen, wobei Abstände zwischen den Elektroden 175 der zweiten kapazitiven Sensoren 185 verkleinert werden, wenn das Hebelelement 140 im Uhrzeigersinn verschwenkt wird.

In anderen Ausführungsformen sind nur ein erster kapazitiver Sensor 180 und/oder nur ein zweiter kapazitiver Sensor 185 vorgesehen. Mehrere kapazitive Sensoren 180, 185 werden üblicherweise elektrisch parallel geschaltet, um die wirksamen Flächen der beteiligten Elektroden 175 zu vergrößern, sodass der Sensor 180, 185 ein größeres elektrisches Signal in Abhängigkeit einer mechanischen Verschwenkung bereitstellt.

Eine Kapazität eines der Sensoren 180, 185 kann beispielsweise mittels eines Spannungspulses bestimmt werden. Die Kapazität jedes Sensors 180, 185 ist üblicherweise umgekehrt proportional zu einem Abstand der beteiligten Elektroden 175. Der Abstand hängt vom Schwenkwinkel 170 und dieser von einer Auslenkung der Membran 130 ab. Auf diese Weise ist eine physikalische Größe, hier eine Beschleunigung, die auf die Auslenkung der Membran 130 wirkt, ursächlich für eine Veränderung der Kapazitäten der kapazitiven Sensoren 180 und 185. Der Zusammenhang zwischen der physikalischen Größe und einer bestimmten Kapazität kann verbessert linearisiert werden, indem die bestimmte Kapazität des ersten kapazitiven Sensors 180 von der bestimmten Kapazität des zweiten kapazitiven Sensors 185 abgezogen wird oder umgekehrt.

Trotzdem ist der Zusammenhang üblicherweise nur für einen relativ kleinen Bereich des Schwenkwinkels 170 linear. Um die Linearität zu verbessern, wird daher vorgeschlagen, einen Aktuator 190 vorzusehen, der eine vorbestimmte Kraft auf das Hebelelement 140 ausübt, um den Schwenkwinkel 170 in einen Bereich zu bringen, in dem der genannte Zusammenhang ausreichend linear ist. Dazu kann ein Paar von Elektroden 175, das dann nicht zur Bildung eines ersten kapazitiven Sensors 180 oder eines zweiten kapazitiven Sensors 185 zur Verfügung steht, mit einer vorbestimmten Stellspannung beaufschlagt werden. In dieser Ausführungsform kann durch einen Aktuator 190 nur eine Anziehungskraft, aber keine Abstoßungskraft ausgeübt werden. Es ist daher bevorzugt, dass zwei der beschriebenen elektrostatischen Aktuatoren 190 an unterschiedlichen Endabschnitten 145, 155 des Hebelelements 140 vorgesehen sind. Ein Paar von Elektroden 175 kann auch alternierend als kapazitiver Sensor 180, 185 und als Aktuator 190 betrieben werden. In einer anderen Ausführungsform kann auch eine andere Art von Aktuator 190 vorgesehen sein, beispielsweise auf der Basis eines Piezoelements.

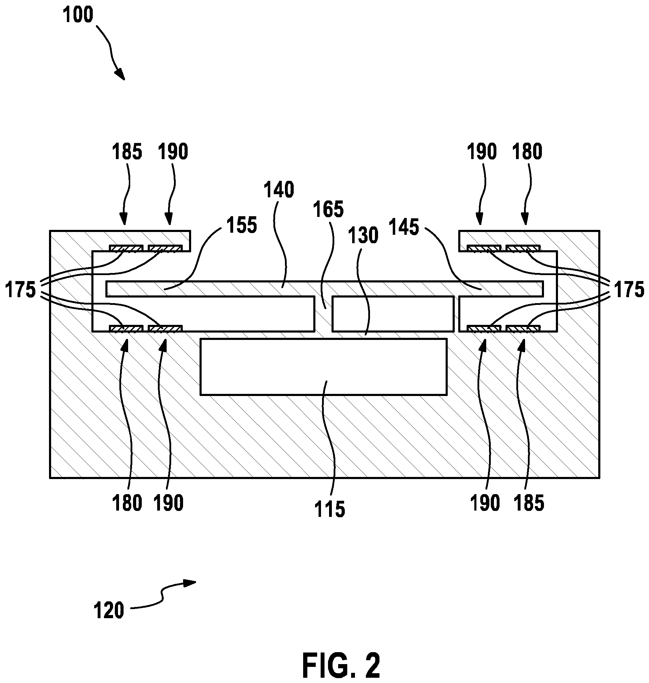

Figur 2 zeigt feinen mikromechanischen Sensor 100 der nicht Teil der Erfindung ist. Der dargestellte mikromechanische Sensor 100 ist dazu eingerichtet, einen pneumatischen Druck in der Umgebung 120 des Sensors 100 zu bestimmen. Dazu ist der Hohlraum 115 auf allen Seiten abgeschlossen. Die Anordnung der Membran 130 und des Hebelelements 140 entspricht der von der bezüglich Figur 1 beschriebenen Ausführungsform. In der dargestellten Ausführungsform sind auf jeder Seite jedes Endabschnitts 145, 155 jeweils zwei Elektroden 175 vorgesehen, sodass der oder die ersten kapazitiven Sensoren 180, der oder die zweiten kapazitiven Sensoren 185 und der oder die Aktuatoren 190 unabhängig voneinander gebildet werden können. In der dargestellten Ausführungsform ist das Hebelelement 140 vollständig leitfähig und wirkt daher insgesamt als Elektrode 175. Rein beispielhaft sind die Aktuatoren 190 jeweils näher am zweiten Gelenkelement 165 als die kapazitiven Sensoren 180, 185 dargestellt, in anderen Ausführungsformen kann die Anordnung jedoch auch verändert sein.

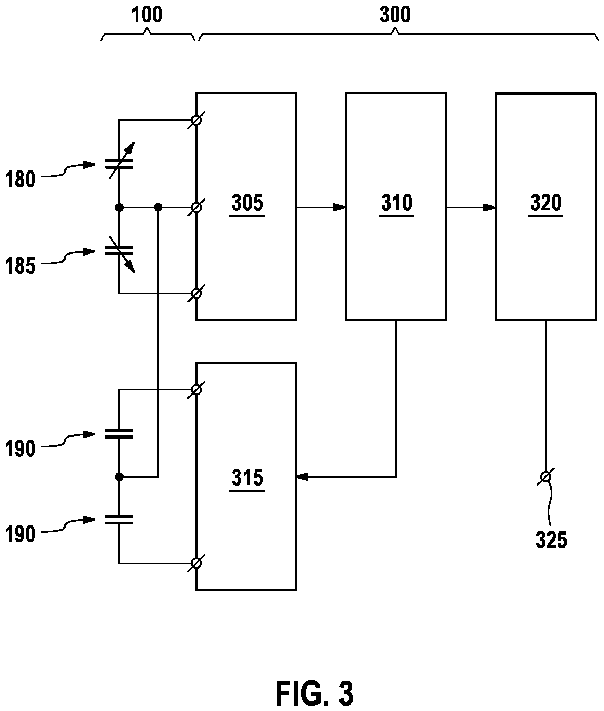

Figur 3 zeigt eine Steuervorrichtung 300 für den mikromechanischen Sensor 100 nach einer der vorangehenden Figuren. Die Steuervorrichtung 300 kann insbesondere in Halbleitertechnik aufgebaut und bevorzugt mit dem mikromechanischen Sensor 100 integriert aufgebaut sein. In einer Ausführungsform umfasst der Sensor 100 die Steuervorrichtung 300. Die Steuervorrichtung 300 ist dazu eingerichtet, den Aktuator 190 mit einer Stellspannung anzusteuern und ein Signal bereitzustellen, das auf die physikalische Größe hinweist, die auf die Membran 130 des mikromechanischen Sensors 100 auslenkend wirken kann.

Die Steuervorrichtung 300 umfasst bevorzugt eine Abtasteinrichtung 305 zur Bestimmung von Kapazitäten der kapazitiven Sensoren 180, 185, einen Filter 310 zur Bestimmung der Stellspannung, eine steuerbare Spannungsquelle 315 zur Bereitstellung der bestimmten Stellspannung an den Aktuator 190, sowie bevorzugt eine Verarbeitungseinrichtung 320 und weiter bevorzugt eine Schnittstelle 325. Die mittels der Abtasteinrichtung 305 bestimmte Kapazität der kapazitiven Sensoren 180, 185 bzw. die Differenz der bestimmten Kapazitäten weist auf den Schwenkwinkel 170 des Hebelelements 140 hin. Der Filter 310 ist bevorzugt dazu eingerichtet, eine Stellspannung zu generieren, die es erlaubt, den Schwenkwinkel 170 entweder auf einen vorbestimmten Wert oder in einen vorbestimmten Bereich zu bringen. Entspricht der Schwenkwinkel 170 dem vorbestimmten Wert, so kann die physikalische Größe, die auf die Membran 130 wirkt, auf der Basis der Stellspannung bestimmt werden. Liegt der Schwenkwinkel 170 lediglich im vorbestimmten Bereich, so wird bevorzugt zusätzlich zur Stellspannung das mittels der Abtasteinrichtung 305 bestimmte Kapazitätssignal zusätzlich ausgewertet, um die physikalische Größe zu bestimmen. Die physikalische Größe wird in beiden Varianten bevorzugt durch die Verarbeitungseinrichtung 320 bestimmt. Dazu kann die Verarbeitungseinrichtung 320 insbesondere einen programmierbaren Mikrocomputer oder Mikrocontroller, in einer bevorzugten Ausführungsform in einer Variante als digitaler Signalprozessor (DSP), umfassen. Der Filter 310 kann ebenfalls von der Verarbeitungseinrichtung 320 umfasst sein oder getrennt von diesem aufgebaut sein. Dabei kann der Filter 310 digital, insbesondere unter Verwendung einer weiteren Verarbeitungseinrichtung, oder analog, insbesondere mittels aktiver und passiver elektronischer Komponenten, aufgebaut werden. Die Verarbeitungseinrichtung 320 stellt bevorzugt an der Schnittstelle 325 ein Signal, insbesondere ein Spannungssignal, bereit, das auf die bestimmte physikalische Größe hinweist.

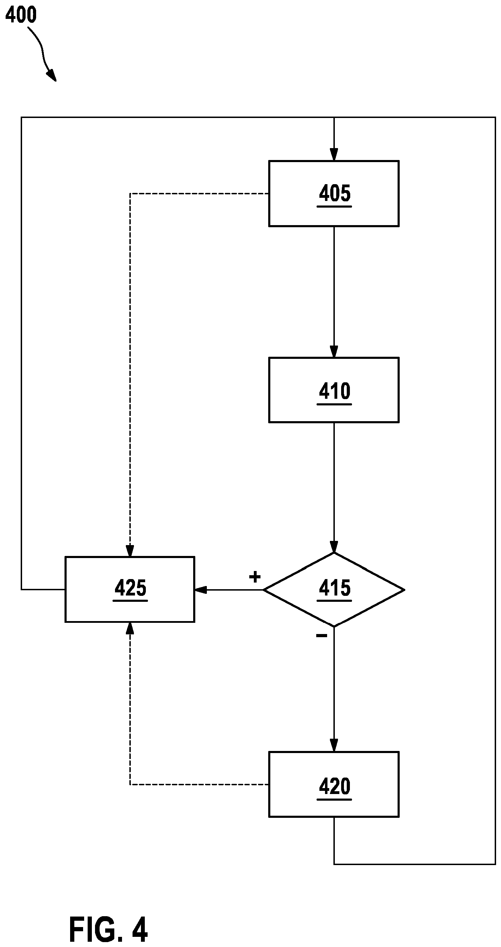

Figur 4 zeigt ein Ablaufdiagramm eines Verfahrens 400 zum Bestimmen einer Messgröße, insbesondere einer physikalischen Größe, die auslenkend auf die Membran 130 eines mikromechanischen Sensors 100 einwirkt. Das Verfahren 400 kann zumindest teilweise als Computerprogrammprodukt auf der Verarbeitungseinrichtung 320 und/oder dem Filter 310 der Steuervorrichtung 300 ablaufen. Es ist allgemein bevorzugt, dass die Steuervorrichtung 300 zur Durchführung des gesamten Verfahrens 400 eingerichtet ist.

In einem Schritt 405 werden Kapazitäten der kapazitiven Sensoren 180, 185 bestimmt. Dazu kann insbesondere ein Spannungspuls auf die Sensoren 180, 185 bewirkt werden. In einem nachfolgenden Schritt 410 wird auf der Basis der bestimmten Kapazitäten der Schwenkwinkel 170 oder eine davon abhängige Größe, beispielsweise die Auslenkung der Membran 130, bestimmt. In einem Schritt 415 wird dann bevorzugt überprüft, ob sich der mikromechanische Sensor 100 in einem vorbestimmten Bereich befindet. Dies ist dann der Fall, wenn der Schwenkwinkel 170 einen vorbestimmten Bereich oder Wert annimmt oder die entsprechende Größe einen korrespondierenden Wert oder Bereich einnimmt. Befindet sich der mikromechanische Sensor 100 nicht im vorbestimmten Bereich, so wird bevorzugt in einem Schritt 420 die Stellung des Hebelelements 140 verändert, indem der Aktuator 190 verändert angesteuert wird, insbesondere indem die Stellspannung des Aktuators 190 verändert wird. Sind mehrere Aktuatoren 190 vorgesehen, so kann deren Ansteuerung gegenläufig verändert werden. Anschließend kann das Verfahren 400 zum Schritt 405 zurückkehren und erneut durchlaufen. Wird hingegen im Schritt 415 bestimmt, dass der Schwenkwinkel 170 den vorbestimmten Wert oder Bereich einnimmt, so wird bevorzugt in einem Schritt 425 auf der Basis der Ansteuerung des Aktuators 190 ein Maß für die physikalische Größe bestimmt und ein Signal, das auf dieses Maß hinweist, bereitgestellt. Anschließend kann das Verfahren 400 ebenfalls zum Schritt 405 zurückkehren und erneut durchlaufen.

Das Verfahren 400 kann in zwei unterschiedlichen Varianten betrieben werden. In einer ersten Variante wird der Aktuator 190 derart angesteuert, dass der Schwenkwinkel 170 möglichst genau einem vorbestimmten Wert entspricht. Die physikalische Größe kann dann allein auf der Basis der Ansteuerung des Aktuators 190 bestimmt werden. In einer zweiten Variante wird der Aktuator 190 nur so angesteuert, dass der Schwenkwinkel 170 in einem vorbestimmten Bereich liegt, in dem bevorzugt ein möglichst linearer Zusammenhang zwischen der physikalischen Größe und einem mittels der kapazitiven Sensoren 180, 185 bestimmbaren Kapazitätssignal liegt. In diesem Fall kann die Ansteuerung des Aktuators 190 gewissermaßen als Grobwert verwendet werden, während der Schwenkwinkel 170 einen Feinwert anzeigt. Das Signal für die physikalische Größe kann auf der Basis einer Summe des Grobwerts und des Feinwerts bestimmt werden. Wird der vorbestimmte Bereich für den Schwenkwinkel 170 ausreichend verkleinert, so nähert sich die zweite beschriebene Variante an die erste an.

## Patentansprüche

1. Mikromechanischer Sensor (100), umfassend:
- ein Substrat (110) mit einem Hohlraum (115);
- eine elastische Membran (130), die den Hohlraum (115) überspannt;
- ein die Membran (130) überspannendes Hebelelement (140) mit einem ersten (145) und einem zweiten Endabschnitt (155) und einem Mittelabschnitt (150), wobei die Endabschnitte (145, 155) auf gegenüberliegenden Seiten des Mittelabschnitts (150) liegen;
- ein erstes Gelenkelement (160), das zwischen dem ersten Endabschnitt (145) und dem Substrat (110) angebracht ist;
- ein zweites Gelenkelement (165), das zwischen dem Mittelabschnitt (150) und der Membran (130) angebracht ist;
- einen ersten und einen zweiten kapazitiven Sensor (180, 185), wobei jeder kapazitive Sensor (180, 185) zwei Elektroden (175) aufweist, von denen eine an einem der Endabschnitte (145, 155) und die andere am Substrat (110) angebracht ist,
- sodass Abstände zwischen den Elektroden (175) verschiedener kapazitiver Sensoren (180, 185) gegenläufig beeinflusst werden, wenn das Hebelelement (140) aufgrund einer Auslenkung der Membran (130) geschwenkt wird, und
- einen Aktuator (190) zur Aufbringung einer Stellkraft zwischen dem Hebelelement (140) und dem Substrat (110),
**dadurch gekennzeichnet, dass**
an der Membran (130) ein Masseelement (135) angebracht ist und der Sensor (100) zur Bestimmung einer Beschleunigung eingerichtet ist.

2. Sensor (100) nach Anspruch 1, wobei der Aktuator (190) eine am Substrat (110) angebrachte erste Elektrode (175) und eine am Hebelelement (140) angebrachte zweite Elektrode (175) umfasst, um eine elektrostatische Anziehungskraft bereitzustellen, wenn an die Elektroden (175) eine Stellspannung angelegt ist.

3. Sensor (100) nach Anspruch 2, wobei zwei Aktuatoren (190) an unterschiedlichen Endabschnitten (145, 155) des Hebelelements (140) vorgesehen sind.

4. Sensor (100) nach einem der vorangehenden Ansprüche, ferner umfassend eine Steuervorrichtung (300) zur Ansteuerung des Aktuators (190) und zur Bestimmung eines von der Auslenkung der Membran (130) abhängigen Signals.

5. Sensor (100) nach Anspruch 4, wobei die Steuervorrichtung (300) dazu eingerichtet ist, das von der Auslenkung der Membran (130) abhängige Signal zusätzlich auf der Basis der Kapazitäten der kapazitiven Sensoren (180, 185) zu bestimmen.

6. Sensor (100) nach einem der vorangehenden Ansprüche, wobei der Hohlraum (115) gegenüber einer Umgebung (120) abgeschlossen ist und der Sensor (100) zur Bestimmung eines atmosphärischen Drucks in der Umgebung (120) eingerichtet ist.

7. Verfahren (400) zum Steuern eines Sensors (100) nach einem der vorangehenden Ansprüche, wobei das Verfahren (400) folgende Schritte umfasst:
- Bestimmen (405) von Kapazitäten der kapazitiven Sensoren (180, 185);
- Ansteuern (420) des Aktuators (190) in Abhängigkeit der bestimmten Kapazitäten, um einen Schwenkwinkel (170) des Hebelelements (140) in einen vorbestimmten Bereich zu bringen; und
- Bestimmen (425) eines von der Auslenkung der Membran (130) abhängigen Beschleunigungssignals auf der Basis der Ansteuerung.

8. Verfahren (400) nach Anspruch 7, wobei das Signal zusätzlich auf der Basis der Kapazitäten der kapazitiven Sensoren (180, 185) bestimmt (425) wird.

9. Verfahren (400) nach Anspruch 7 oder 8, bezogen auf Anspruch 2, wobei die Elektroden (175) eines der kapazitiven Sensoren (180, 185) mit den Elektroden (175) des Aktuators (190) zusammenfallen und das Verfahren (400) das Ansteuern der Elektroden (175) in rascher Folge abwechselnd als kapazitiver Sensor (180, 185) und als Aktuator (190) umfasst.

## Claims

1. Micromechanical sensor (100), comprising:
- a substrate (110) with a cavity (115);
- an elastic membrane (130), which is made to extend over the cavity (115);
- a lever element (140), which is made to extend over the membrane (130) and has a first end portion (145) and a second end portion (155) and a middle portion (150), the end portions (145, 155) lying on opposite sides of the middle portion (150);
- a first joint element (160), which is attached between the first end portion (145) and the substrate (110);
- a second joint element (165), which is attached between the middle portion (150) and the membrane (130);
- a first and a second capacitive sensor (180, 185), each capacitive sensor (180, 185) having two electrodes (175), of which one is attached to one of the end portions (145, 155) and the other is attached to the substrate (110),
- so that spacings between the electrodes (175) of different capacitive sensors (180, 185) are influenced oppositely when the lever element (140) is pivoted as a result of a deflection of the membrane (130), and
- an actuator (190) for applying an actuating force between the lever element (140) and the substrate (110),
**characterized in that**
a mass element (135) is attached to the membrane (130) and the sensor (100) is designed for determining an acceleration.

2. Sensor (100) according to Claim 1, the actuator (190) comprising a first electrode (175), attached to the substrate (110), and a second electrode (175), attached to the lever element (140), in order to provide an electrostatic force of attraction when an actuating voltage is applied to the electrodes (175).

3. Sensor (100) according to Claim 2, two actuators (190) being provided at different end portions (145, 155) of the lever element (140).

4. Sensor (100) according to one of the preceding claims, also comprising a control device (300) for activating the actuator (190) and for determining a signal dependent on the deflection of the membrane (130).

5. Sensor (100) according to Claim 4, the control device (300) being designed to determine the signal that is dependent on the deflection of the membrane (130) additionally on the basis of the capacitances of the capacitive sensors (180, 185) .

6. Sensor (100) according to one of the preceding claims, the cavity (115) being closed off with respect to a surrounding space (120) and the sensor (100) being designed for determining an atmospheric pressure in the surrounding space (120) .

7. Method (400) for controlling a sensor (100) according to one of the preceding claims, the method (400) comprising the following steps:
- determining (405) capacitances of the capacitive sensors (180, 185);
- activating (420) the actuator (190) in dependence on the capacitances determined, in order to bring a pivoting angle (170) of the lever element (140) into a predetermined range; and
- determining (425) on the basis of the activation an acceleration signal dependent on the deflection of the membrane (130).

8. Method (400) according to Claim 7, the signal additionally being determined (425) on the basis of the capacitances of the capacitive sensors (180, 185).

9. Method (400) according to Claim 7 or 8, with reference to Claim 2, the electrodes (175) of one of the capacitive sensors (180, 185) coinciding with the electrodes (175) of the actuator (190) and the method (400) comprising actuating the electrodes (175) alternately as a capacitive sensor (180, 185) and as an actuator (190) in quick succession.

## Revendications

1. Capteur micromécanique (100), comprenant :
- un substrat (110) doté d'une cavité (115) ;
- une membrane élastique (130) recouvrant la cavité (115) ;
- un élément de levier (140) recouvrant la membrane (130) et doté d'une première (145) et d'une deuxième (155) partie d'extrémité et d'une partie centrale (150), les parties d'extrémité (145, 155) étant situées sur des côtés opposés de la partie centrale (150) ;
- un premier élément articulé (160) qui est monté entre la première partie d'extrémité (145) et le substrat (110) ;
- un deuxième élément articulé (165) qui est monté entre la partie centrale (150) et la membrane (130) ;
- un premier et un deuxième capteur capacitif (180, 185), chaque capteur capacitif (180, 185) présentant deux électrodes (175) dont l'une est montée à l'une des parties d'extrémité (145, 155) et l'autre est montée sur le substrat (110),
- de sorte que les distances entre les électrodes (175) de différents capteurs capacitifs (180, 185) sont affectées en sens opposé si l'élément de levier (140) est amené à pivoter en raison d'une déviation de la membrane (130), et
- un actionneur (190) pour exercer une force de réglage entre l'élément de levier (140) et le substrat (110),
**caractérisé en ce qu'**un élément à la masse (135) est monté au niveau de la membrane (130), et **en ce que** le capteur (100) est conçu pour déterminer une accélération.

2. Capteur (100) selon la revendication 1, dans lequel l'actionneur (190) comprend une première électrode (175) montée sur le substrat (110) et une deuxième électrode (175) montée sur l'élément de levier (140) pour fournir une force d'attraction électrostatique si une tension de réglage est appliquée aux électrodes (175).

3. Capteur (100) selon la revendication 2, dans lequel deux actionneurs (190) sont prévus sur des parties d'extrémité différentes (145, 155) de l'élément de levier (140).

4. Capteur (100) selon l'une quelconque des revendications précédentes, comprenant en outre un dispositif de commande (300) pour piloter l'actionneur (190) et pour déterminer un signal dépendant de la déviation de la membrane (130).

5. Capteur (100) selon la revendication 4, dans lequel le dispositif de commande (300) est conçu pour déterminer le signal dépendant de la déviation de la membrane (130) en plus sur la base des capacités des capteurs capacitifs (180, 185).

6. Capteur (100) selon l'une quelconque des revendications précédentes, la cavité (115) étant fermée par rapport à un environnement (120), et le capteur (100) étant conçu pour déterminer une pression atmosphérique dans l'environnement (120).

7. Procédé (400) permettant de commander un capteur (100) selon l'une quelconque des revendications précédentes, le procédé (400) comprenant les étapes suivantes consistant à :
- déterminer (405) des capacités des capteurs capacitifs (180, 185) ;
- piloter (420) l'actionneur (190) en fonction des capacités déterminées afin d'amener un angle de pivotement (170) de l'élément de levier (140) dans une plage prédéterminée ; et
- déterminer (425) un signal d'accélération dépendant de la déviation de la membrane (130) sur la base du pilotage.

8. Procédé (400) selon la revendication 7, dans lequel le signal est déterminé (425) en outre sur la base des capacités des capteurs capacitifs (180, 185).

9. Procédé (400) selon la revendication 7 ou 8, en se référant à la revendication 2, les électrodes (175) d'un des capteurs capacitifs (180, 185) coïncidant avec les électrodes (175) de l'actionneur (190), et le procédé (400) comprenant le pilotage des électrodes (175) en alternance rapide en tant que capteur capacitif (180, 185) et en tant qu'actionneur (190).
